# EUROPEAN PATENT SPECIFICATION

(11) **EP 4 498 765 B1**
(45) Date of publication and mention of the grant of the patent: **17.06.2026**
(21) Application number: 23848955.3
(22) Date of filing: 28.04.2023
(51) Int. Cl.: H05K 1/11, H05K 1/02, H05K 1/18, H05K 1/181, H05K 3/34, H05K 3/341

(54) **CIRCUIT BOARD, CIRCUIT BOARD ASSEMBLY AND ELECTRONIC DEVICE**
LEITERPLATTE, LEITERPLATTENANORDNUNG UND ELEKTRONISCHE VORRICHTUNG
CARTE DE CIRCUIT IMPRIMÉ, ENSEMBLE CARTE DE CIRCUIT IMPRIMÉ ET DISPOSITIF ÉLECTRONIQUE

(30) Priority: 05.08.2022 CN 202210938637
(43) Date of publication of application: 29.01.2025
(73) Proprietor: Honor Device Co., Ltd., Shenzhen, Guangdong 518040 (CN)
(72) Inventor: ZHOU, Yawei, Shenzhen, Guangdong 518040 (CN); LV, Ye, Shenzhen, Guangdong 518040 (CN)
(74) Representative: MERH-IP Matias Erny Reichl Hoffmann Patentanwälte PartG mbB
(86) International application number: PCT/CN2023/091770
(87) International publication number: WO 2024/027244

(56) References cited:
- CN-A- 104 284 517
- CN-A- 106 455 306
- CN-A- 106 455 306
- CN-A- 109 445 649
- CN-A- 113 395 828
- CN-A- 113 395 828
- CN-U- 211 630 498
- JP-A- 2004 022 734

## Description

### TECHNICAL FIELD

This application relates to the field of communication technologies, and in particular, to a circuit board, a circuit board assembly, and an electronic device.

### BACKGROUND

In an electronic device such as a mobile phone, a main board is generally in elastic conduction with electronic components such as a motor and a speaker through elastic pieces, and positions of a solder pad and the elastic piece on the main board and a corresponding electronic component are relatively fixed in matching positions. When two electronic components such as motors are provided and have different directions, corresponding positions of the elastic pieces on the main board are different, so that different main boards are required to adapt to different electronic components, resulting in low utilization of the main board.

CN113395828A and CN106455306A disclose a type of solder pad comprising one common solder pad which offers more mounting possibilities for an electrical component (resistor), where one terminal of the electrical component is always connected to the common solder pad.

CN104284517A discloses several common solder pads, where each type of solder pad comprises just one common solder pad. This offers more mounting possibilities for an electrical component (resistor), where each resistor is assigned to a set of one common solder pad and one independent solder pad.

### SUMMARY

This application provides a circuit board, a circuit board assembly, and an electronic device, to resolve a technical problem of low utilization of a main board in the related art.

The invention is defined by the appended claims.

### BRIEF DESCRIPTION OF DRAWINGS

To describe the technical solutions in the embodiments of this application or the background more clearly, the following briefly describes the accompanying drawings required for describing the embodiments of this application or the background.
FIG. 1 is a schematic diagram of a structure of an electronic device according to an embodiment of this application;
FIG. 2 is a schematic diagram of a partial structure of the electronic device shown in FIG. 1;
FIG. 3 is a schematic diagram of a structure of a circuit board assembly in the electronic device shown in FIG. 1 in a first scenario;
FIG. 4 is a schematic diagram of a structure of the circuit board assembly shown in FIG. 3 in a second scenario;
FIG. 5 is a schematic diagram of a structure of a circuit board in the circuit board assembly shown in FIG. 3;
FIG. 6 is a schematic enlarged view of a structure of a solder pad in the circuit board shown in FIG. 5;
FIG. 7 is a schematic diagram of a partial structure of a circuit board according to a comparative example;
FIG. 8 is a schematic diagram of a partial structure of a circuit board according to another comparative example; and
FIG. 9 is a schematic diagram of a partial structure of a circuit board according to a further comparative example.

### DESCRIPTION OF EMBODIMENTS

The following describes the embodiments of this application with reference to the accompanying drawings in the embodiments of this application.

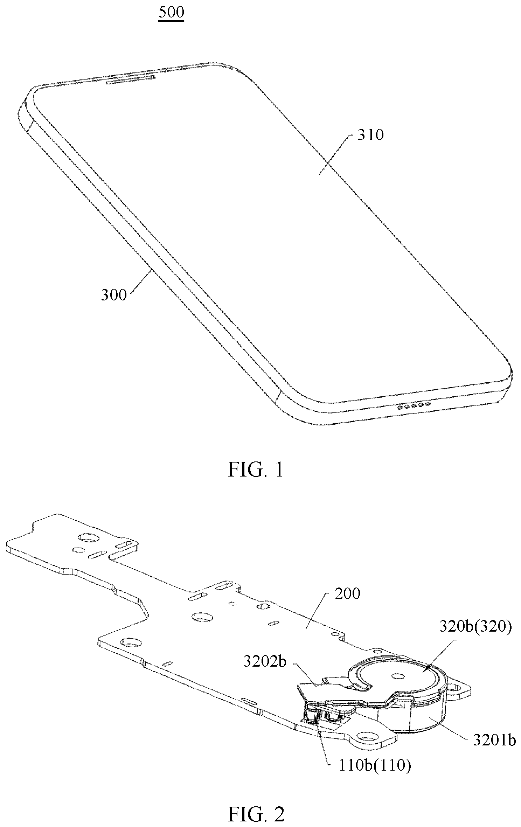

Refer to FIG. 1 and FIG. 2. FIG. 1 is a schematic diagram of a structure of an electronic device 500 according to an embodiment of this application, and FIG. 2 is a schematic diagram of a partial structure of the electronic device 500 shown in FIG. 1.

This application provides an electronic device 500. The electronic device 500 includes, but is not limited to, electronic products such as a cellphone (cellphone), a notebook computer (noteBook computer), a tablet personal computer (tablet personal computer), a laptop computer (laptop computer), a personal digital assistant (personal digital assistant, PDA), or a wearable device (wearable device). Descriptions are provided below by using an example in which the electronic device 500 is a cellphone.

The electronic device 500 includes a housing 300, a display screen 310, a circuit board assembly 200, and an electronic component 320. The display screen 310 is mounted on the housing 300, and encloses an accommodating space (not shown in the figure) with the housing 300. Both the circuit board assembly 200 and the electronic component 320 are located in the accommodating space and fixedly connected to the housing 300, and the electronic component 320 is electrically connected to the circuit board assembly 200. In this embodiment, the electronic component 320 is a motor. In other embodiments, the electronic component 320 may alternatively be a speaker or another electronic component. The electronic component 320 may be a first component (not shown in the figure), or may be a second component 320b. The electronic component 320 shown in FIG. 2 is the second component 320b.

The first component includes a first body, a first circuit board, and a first electrode (not shown in the figure). The first circuit board is a flexible printed circuit (Flexible Printed Circuit, FPC). The first electrode includes a first positive electrode and a first negative electrode. The first positive electrode and the first negative electrode are arranged side by side and spaced apart, and both the first positive electrode and the first negative electrode are arranged on the first circuit board and electrically connected to the first circuit board. The first circuit board is fixedly connected and electrically connected to the first body. The first electrode is configured to be electrically connected to the main board, so that the first component is electrically connected to the main board.

The second component 320b includes a second body 3201b, a second circuit board 3202b, and a second electrode (not marked in the figure). The second electrode includes a second positive electrode and a second negative electrode. The second positive electrode and the second negative electrode are arranged side by side and spaced apart, and both the second positive electrode and the second negative electrode are arranged on the second circuit board 3202b, and electrically connected to the second circuit board 3202b. The second circuit board 3202b is fixedly connected and electrically connected to the second body 3201b. The second electrode is configured to be electrically connected to the main board, so that the second component 320b is electrically connected to the main board.

The second component 320b and the first component may be a same type of electronic component in which a circuit board direction is inconsistent with an electrode direction, or may be different types of electronic components. In this embodiment, a difference between the second component 320b and the first component lies in that a position of the first circuit board relative to the first body is different from a position of the second circuit board 3202b relative to the second body 3201b, and orientations of the first electrode and the second electrode are different. In this embodiment, the first circuit board and the second circuit board 3202b are mirror symmetrical structures, and the first electrode and the second electrode are mirror symmetrical structures. In other words, when the first component and the second component 320b are mounted on the circuit board assembly 200, the first electrode and the second electrode correspond to different positions on the circuit board.

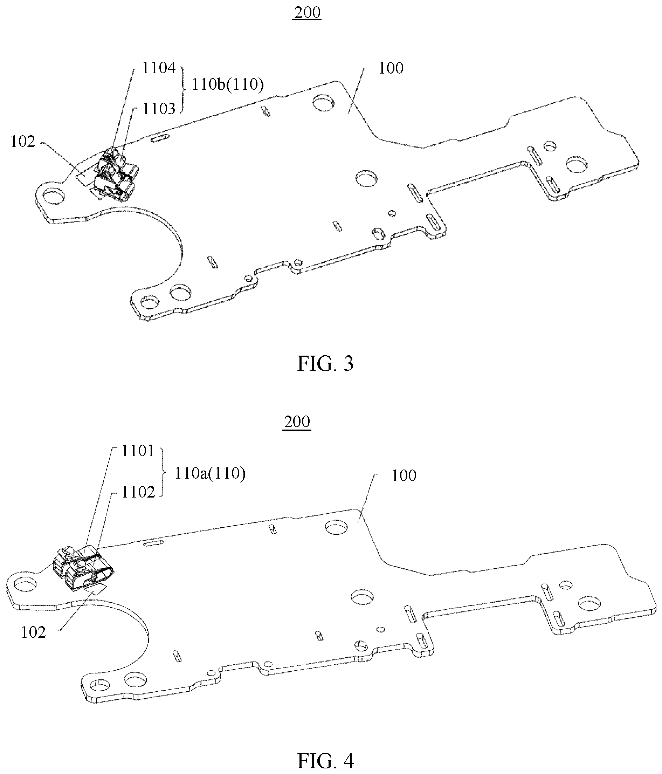

Refer to FIG. 3 and FIG. 4. FIG. 3 is a schematic diagram of a structure of the circuit board assembly 200 in the electronic device 500 shown in FIG. 1 in a first scenario, and FIG. 4 is a schematic diagram of a structure of the circuit board assembly 200 shown in FIG. 3 in a second scenario.

The circuit board assembly 200 includes a circuit board 100 and an elastic piece 110. The circuit board 100 includes a main board 101 and a solder pad 102. The solder pad 102 is arranged on a surface of the main board 101, and is electrically connected to the main board 101. The elastic piece 110 is soldered onto the solder pad 102, and is fixedly connected and electrically connected to the solder pad 102. The elastic piece 110 is configured to be electrically connected to the electronic component 320, so that the electronic component 320 is electrically connected to the main board 101. The elastic piece 110 may be a first elastic piece 110a or a second elastic piece 110b.

As shown in FIG. 3, in the first scenario, the electronic component 320 is the second component 320b, and the elastic piece 110 is the second elastic piece 110b. In this embodiment, the second elastic piece 110b includes a second positive elastic piece 1103 and a second negative elastic piece 1104. Both the second positive elastic piece 1103 and the second negative elastic piece 1104 are fixedly connected and electrically connected to the solder pad 102, and the second positive elastic piece 1103 and the second negative elastic piece 1104 are arranged side by side and spaced apart. The second positive elastic piece 1103 is configured to be electrically connected to the second positive electrode of the second component 320b, and the second negative elastic piece 1104 is configured to be electrically connected to the second negative electrode, so that the second component 320b is electrically connected to the main board 101.

As shown in FIG. 4, in the second scenario, the electronic component 320 is the first component, and the elastic piece 110 is the first elastic piece 110a. In this embodiment, the first elastic piece 110a includes a first positive elastic piece 1101 and a first negative elastic piece 1102. Both the first positive elastic piece 1101 and the first negative elastic piece 1102 are fixedly connected and electrically connected to the solder pad 102, and the first positive elastic piece 1101 and the first negative elastic piece 1102 are arranged side by side and spaced apart. The first positive elastic piece 1101 is configured to be electrically connected to the first positive electrode of the first component, and the first negative elastic piece 1102 is configured to be electrically connected to the first negative electrode, so that the first component is electrically connected to the main board 101.

The following specifically describes the structure of the circuit board 100.

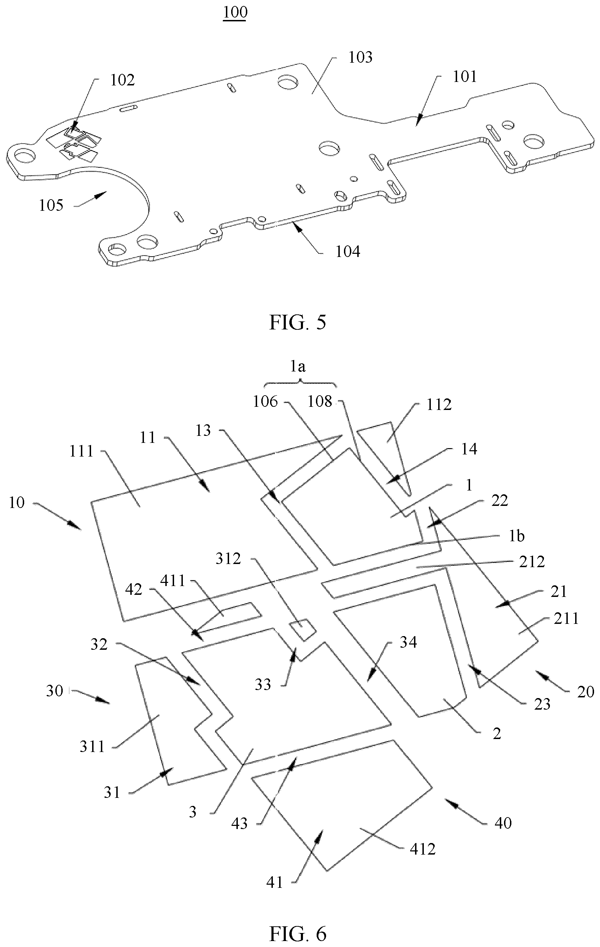

Refer to FIG. 5 and FIG. 6. FIG. 5 is a schematic diagram of the structure of the circuit board 100 in the circuit board assembly 200 shown in FIG. 3, and FIG. 6 is a schematic enlarged view of a structure of the solder pad 102 in the circuit board 100 shown in FIG. 5.

The circuit board 100 includes the main board 101 and the solder pad 102. The solder pad 102 is arranged on the main board 101, and is fixedly connected and electrically connected to the main board 101. In this embodiment, the main board 101 is a printed circuit board (Printed Circuit Board, PCB). In other embodiments, the main board 101 may alternatively be a flexible circuit board. The main board 101 includes a first surface 103 and a second surface 104. The first surface 103 is arranged opposite to the second surface 104. The main board 101 is provided with a mounting groove 105. The mounting groove 105 is provided on a side surface of the main board 101, and runs through the first surface 103 and the second surface 104. The mounting groove 105 is configured to mount the electronic component 320. A circuit is arranged on the main board 101. The circuit includes a positive electrode circuit and a negative electrode circuit (which are not shown in the figure). The solder pad 102 is arranged on the first surface 103 of the main board 101, and is electrically connected to the circuit of the main board 101.

The solder pad 102 includes a first type of solder pad 10, a second type of solder pad 20, a third type of solder pad 30, and a fourth type of solder pad 40. The first type of solder pad 10 and the third type of solder pad 30 are arranged side by side and spaced apart. In this embodiment, both an outer contour of the first type of solder pad 10 and an outer contour of the third type of solder pad 30 are rectangular. In other embodiments, the outer contour of the first type of solder pad 10 and the outer contour of the third type of solder pad 30 may alternatively be elliptical, circular, T-shaped, or may be in another shape. The first type of solder pad 10 and the third type of solder pad 30 are configured to be simultaneously connected to the first component. The second type of solder pad 20 and the fourth type of solder pad 40 are arranged side by side and spaced apart. In this embodiment, both an outer contour of the second type of solder pad 20 and an outer contour of the fourth type of solder pad 40 are T-shaped. In other implementations, the outer contour of the second type of solder pad 20 and the outer contour of the fourth type of solder pad 40 may alternatively be rectangular, elliptical, or may be in another shape. The second type of solder pad 20 and the fourth type of solder pad 40 are configured to be simultaneously connected to the second component 320b.

The first type of solder pad 10 includes a first solder pad 11 and a first common solder pad 1. The first common solder pad 1 includes a first side 1a and a second side 1b. The first solder pad 11 is located on the first side 1a. The first side 1a includes a first sub-side 106 and a second sub-side 108. The first solder pad 11 includes a first sub-solder pad 111 and a second sub-solder pad 112. The first sub-solder pad 111 is located on the first sub-side 106, and the second sub-solder pad 112 is located on the second sub-side 108. The first common solder pad 1 is located between the first sub-solder pad 111 and the second sub-solder pad 112, and is spaced apart from the first sub-solder pad 111 and the second sub-solder pad 112. A first gap is provided between the first solder pad 11 and the first common solder pad 1. The first gap includes a first sub-gap 13 and a second sub-gap 14. The first sub-gap 13 is a gap between the first sub-solder pad 111 and the first common solder pad 1. A width of the first sub-gap 13 ranges from 0.15 mm to 0.25 mm. The second sub-gap 14 is a gap between the second sub-solder pad 112 and the first common solder pad 1, and a width of the second sub-gap 14 ranges from 0.15 mm to 0.25 mm. The first sub-gap 13 and the second sub-gap 14 surround the first side 1a of the first common solder pad 1. It may be understood that the first sub-gap 13 and the second sub-gap 14 separate the first type of solder pad 10 into the first sub-solder pad 111, the second sub-solder pad 112, and the first common solder pad 1.

Both the first solder pad 11 and the first common solder pad 1 are solders. In this embodiment, the solder is a tin solder. In other embodiments, a material of the solder may alternatively be copper or silver. Both the first sub-gap 13 and the second sub-gap 14 are filled with a solder resist. In this embodiment, the gaps are provided between the first solder pad 11 and the first common solder pad 1, and the solder resist is arranged in the gaps, so that the first solder pad 11 can be separated from the first common solder pad 1, thereby preventing the solder from flowing between the first solder pad 11 and the first common solder pad 1.

In this embodiment, a proportion of a total area of the first solder pad 11 and the first common solder pad 1 to a total area of the first solder pad 11, the first common solder pad 1, the first sub-gap 13, and the second sub-gap 14 is greater than or equal to 80%. In other words, a total area of the first sub-gap 13 and the second sub-gap 14 is less than or equal to 20% of the total area of the first solder pad 11, the first common solder pad 1, the first sub-gap 13, and the second sub-gap 14. It may be understood that the total area of the first solder pad 11, the first common solder pad 1, the first sub-gap 13, and the second sub-gap 14 is an original area of the first type of solder pad 10, and the total area of the first solder pad 11 and the first common solder pad 1 is an area occupied by the solder after the first type of solder pad 10 is separated, that is, a soldering area. In this embodiment, the soldering area of the first type of solder pad 10 is set to at least 80% of the original area of the first type of solder pad 10, so that soldering strength can be ensured.

The second type of solder pad 20 includes the first common solder pad 1, a second common solder pad 2, and a second solder pad 21. The second solder pad 21 is located on the second side 1b of the first common solder pad 1, and is spaced apart from the first common solder pad 1. The second solder pad 21 includes a first extending body 211 and a second extending body 212. The first extending body 211 is fixedly connected to the second extending body 212. The first common solder pad 1 and the second common solder pad 2 are arranged side by side and spaced apart in a length direction of the second type of solder pad 20, the second common solder pad 2 and the first extending body 211 are arranged side by side in a width direction of the third type of solder pad 30, and the second extending body 212 is located between the first common solder pad 1 and the second common solder pad 2. A third gap 22 is provided between the second solder pad 21 and the first common solder pad 1. A width of the third gap 22 ranges from 0.15 mm to 0.25 mm. A fourth gap 23 is provided between the second solder pad 21 and the second common solder pad 2. A width of the fourth gap 23 ranges from 0.15 mm to 0.25 mm. It may be understood that the third gap 22 and the fourth gap 23 separate the second type of solder pad 20 into the second solder pad 21, the first common solder pad 1, and the second common solder pad 2.

The first common solder pad 1, the second common solder pad 2, and the second solder pad 21 are all solders. Both the third gap 22 and the fourth gap 23 are filled with the solder resist. In this embodiment, gaps are provided between the second solder pad 21 and the first common solder pad 1 and between the second solder pad 21 and the second common solder pad 2, and the solder resist is arranged in the gaps, so that the second solder pad 21 can be separated from the first common solder pad 1 and the second common solder pad 2, thereby preventing the solder from flowing between the second solder pad 21 and the first common solder pad 1 or flowing between the second solder pad 21 and the second common solder pad 2.

In this embodiment, a total area of the second solder pad 21, the first common solder pad 1, and the second common solder pad 2 is an actual soldering area of the second type of solder pad 20. A total area of the second solder pad 21, the first common solder pad 1, the second common solder pad 2, the third gap 22, and the fourth gap 23 is an original area of the second type of solder pad 20. In this embodiment, a soldering area of the second type of solder pad 20 is at least 80% of the original area of the second type of solder pad 20, so that the soldering strength can be ensured. In other words, a total area of the third gap 22 and the fourth gap 23 is less than or equal to 20% of the total area of the first common solder pad 1, the second solder pad 21, the second common solder pad 2, the third gap 22, and the fourth gap 23.

The length direction of the second type of solder pad 20 intersects with a length direction of the first type of solder pad 10. The first common solder pad 1 is a solder pad shared by the first type of solder pad 10 and the second type of solder pad 20. In other words, the first common solder pad 1 is used as both a part of the first type of solder pad 10 and a part of the second type of solder pad 20. The first common solder pad 1 and the first solder pad 11 are configured to be simultaneously connected to the first component. The first common solder pad 1, the second common solder pad 2, and the second solder pad 21 are configured to be simultaneously connected to the second component 320b. In this embodiment, the first common solder pad 1 is arranged, and the first common solder pad 1 is used as both a part of the first type of solder pad 10 and a part of the second type of solder pad 20, so that an area of the solder pad 102 can be reduced.

A region in which the first solder pad 11 and the first common solder pad 1 are located is a first region, and a region in which the second solder pad 21, the first common solder pad 1, and the second common solder pad 2 are located is a second region. In this embodiment, the first region and the second region have different lengths and widths. In other embodiments, the first region and the second region may have different lengths and a same width; or have a same width and different lengths.

Still refer to FIG. 6. The third type of solder pad 30 includes a third solder pad 31, the second common solder pad 2, and a third common solder pad 3. The third solder pad 31 includes a seventh sub-solder pad 311 and an eighth sub-solder pad 312. The seventh sub-solder pad 311, the third common solder pad 3, the eighth sub-solder pad 312, and the second common solder pad 2 are spaced apart in a length direction of the third type of solder pad 30. A first clearance 32 is provided between the seventh sub-solder pad 311 and the third common solder pad 3. A width of the first clearance 32 ranges from 0.15 mm to 0.25 mm. A second clearance 33 is provided between the eighth sub-solder pad 312 and the third common solder pad 3. A width of the second clearance 33 ranges from 0.15 mm to 0.25 mm. A third clearance 34 is provided between the second common solder pad 2, and the third common solder pad 3 and the eighth sub-solder pad 312. A width of the third clearance 34 ranges from 0.15 mm to 0.25 mm. It may be understood that, the first clearance 32, the second clearance 33, and the third clearance 34 separate the third type of solder pad 30 into four parts: the seventh sub-solder pad 311, the second common solder pad 2, the eighth sub-solder pad 312, and the third common solder pad 3.

The third solder pad 31, the second common solder pad 2, and the third common solder pad 3 are all solders. All the first clearance 32, the second clearance 33, and the third clearance 34 are filled with the solder resist. In this embodiment, the clearances are arranged between the third solder pad 31, the second common solder pad 2, and the third common solder pad 3, and the solder resist is arranged in the clearances, so that the third solder pad 31, the second common solder pad 2, and the third common solder pad 3 can be separated, thereby preventing the solder from flowing between any two adjacent regions of the third solder pad 31, the second common solder pad 2, and the third common solder pad 3.

In this embodiment, a total area of the third solder pad 31, the second common solder pad 2, and the third common solder pad 3 is an actual soldering area of the third type of solder pad 30. A total area of the third solder pad 31, the second common solder pad 2, the third common solder pad 3, the first clearance 32, the second clearance 33, and the third clearance 34 is an original area of the third type of solder pad 30. In this embodiment, a soldering area of the third type of solder pad 30 is at least 80% of the original area of the third type of solder pad 30, so that the soldering strength can be ensured. In other words, a total area of the first clearance 32, the second clearance 33, and the third clearance 34 is less than or equal to 20% of the total area of the third solder pad 31, the second common solder pad 2, the third common solder pad 3, the first clearance 32, the second clearance 33, and the third clearance 34.

As shown in FIG. 6, the length direction of the third type of solder pad 30 is parallel to the length direction of the first type of solder pad 10, and is arranged side by side with and spaced apart from the first type of solder pad 10. The length direction of the third type of solder pad 30 intersects with the length direction of the second type of solder pad 20. The second common solder pad 2 is the solder pad 102 shared by the second type of solder pad 20 and the third type of solder pad 30. In other words, the second common solder pad 2 is used as both a part of the second type of solder pad 20 and a part of the third type of solder pad 30. The second common solder pad 2, the first common solder pad 1, and the second solder pad 21 are configured to be simultaneously connected to the second component 320b. The second common solder pad 2, the third common solder pad 3, and the third solder pad 31 are configured to be simultaneously connected to the first component. In this embodiment, the second common solder pad 102 is arranged, and the second common solder pad 102 is used as both a part of the second type of solder pad 20 and a part of the third type of solder pad 30, so that the area of the solder pad 102 can be reduced.

The fourth type of solder pad 40 includes the third common solder pad 3 and a fourth solder pad 41. The fourth solder pad 41 includes a fifth sub-solder pad 411 and a sixth sub-solder pad 412. The fifth sub-solder pad 411, the third common solder pad 3, and the sixth sub-solder pad 412 are spaced apart in a length direction of the fourth type of solder pad 40, and the third common solder pad 3 is located between the fifth sub-solder pad 411 and the sixth sub-solder pad 412. A fourth clearance 42 is provided between the fifth sub-solder pad 411 and the third common solder pad 3. A width of the fourth clearance 42 ranges from 0.15 mm to 0.25 mm. A fifth clearance 43 is provided between the sixth sub-solder pad 412 and the third common solder pad 3. The width of the fifth clearance 43 ranges from 0.15 mm to 0.25 mm.

Both the third common solder pad 3 and the fourth solder pad 41 are solders. Both the fourth clearance 42 and the fifth clearance 43 are filled with the solder resist. In this embodiment, the clearances are provided between the fourth solder pad 41 and the third common solder pad 3, and the solder resist is arranged in the clearances, so that the fourth solder pad 41 and the third common solder pad 3 can be separated, thereby preventing the solder from flowing between the fourth solder pad 41 and the third common solder pad 3.

In this embodiment, a total area of the fourth solder pad 41 and the third common solder pad 3 is an actual soldering area of the fourth type of solder pad 40. A total area of the fourth solder pad 41, the third common solder pad 3, the fourth clearance 42, and the fifth clearance 43 is an original area of the fourth type of solder pad 40. In this embodiment, a soldering area of the fourth type of solder pad 40 is at least 80% of the original area of the fourth type of solder pad 40, so that the soldering strength can be ensured. In other words, a total area of the fourth clearance 42 and the fifth clearance 43 is less than or equal to 20% of the total area of the fourth solder pad 41, the third common solder pad 3, the fourth clearance 42, and the fifth clearance 43.

The length direction of the fourth type of solder pad 40 is parallel to the length direction of the second type of solder pad 20, and is arranged side by side with and spaced apart from the second type of solder pad 20. The length direction of the fourth type of solder pad 40 intersects with the length direction of the third type of solder pad 30. The third common solder pad 3 is the solder pad 102 shared by the third type of solder pad 30 and the fourth type of solder pad 40. In other words, the third common solder pad 3 is used as both a part of the third type of solder pad 30 and a part of the fourth type of solder pad 40. The third common solder pad 3 and the fourth solder pad 41 are configured to be simultaneously connected to the second component 320b. The third common solder pad 3, the second common solder pad 2, and the third solder pad 31 are configured to be simultaneously connected to the first component. In this embodiment, the third common solder pad 3 is arranged, and the third common solder pad 3 is used as both a part of the third type of solder pad 30 and a part of the fourth type of solder pad 40, so that the area of the solder pad 102 can be reduced.

The first type of solder pad 10 and the third type of solder pad 30 are configured to be simultaneously connected to the first component. In this case, the second solder pad 21 and the fourth solder pad 41 are vacant. The second type of solder pad 20 and the fourth type of solder pad 40 are configured to be simultaneously connected to the second component 320b. In this case, the first solder pad 11 and the third solder pad 31 are vacant. This embodiment may be implemented in the following implementations.

In a first implementation, the first sub-solder pad 111, the second sub-solder pad 112, the first common solder pad 1, and the second solder pad 21 are all electrically connected to the positive electrode circuit of the main board 101, and are used as a positive electrode of the main board 101. The seventh sub-solder pad 311, the eighth sub-solder pad 312, the fifth sub-solder pad 411, the sixth sub-solder pad 412, and the third common solder pad 3 are all electrically connected to the negative electrode circuit of the main board 101, and are used as a negative electrode of the main board 101. The second common solder pad 2 is insulated from the main board 101, and is not electrically connected to the positive electrode circuit of the main board 101 nor electrically connected to the negative electrode circuit of the main board 101. In other words, the second common solder pad 2 is used for fixed connection, and is neither used as the positive electrode of the main board 101 nor used as the negative electrode of the main board 101.

Refer to FIG. 4 and FIG. 6 together. When the electronic component 320 is the first component, the elastic piece 110 is the first elastic piece 110a. The first positive elastic piece 1101 is soldered onto the first type of solder pad 10, and the first negative elastic piece 1102 is soldered onto the third type of solder pad 30. The first positive electrode of the first component is electrically connected to the first positive elastic piece 1101, and the first negative electrode is electrically connected to the first negative elastic piece 1102. The first positive elastic piece 1101 is simultaneously soldered onto the first sub-solder pad 111, the first common solder pad 1, and the second sub-solder pad 112 of the first type of solder pad 10. The positive electrode circuit of the main board 101 is conducted to the first positive elastic piece 1101 simultaneously through the first sub-solder pad 111, the second sub-solder pad 112, and the first common solder pad 1, to be conducted to the first positive electrode of the first component. The first negative elastic piece 1102 is simultaneously soldered onto the seventh sub-solder pad 311, the eighth sub-solder pad 312, the second common solder pad 2, and the third common solder pad 3 of the third type of solder pad 30. The negative electrode circuit of the main board 101 is conducted to the first negative elastic piece 1102 simultaneously through the seventh sub-solder pad 311, the eighth sub-solder pad 312, and the third common solder pad 3, to be conducted to the first negative electrode of the first component, so that the first component is electrically connected to the main board 101.

Refer to FIG. 3 and FIG. 6 together. When the electronic component 320 is the second component 320b, the elastic piece 110 is the second elastic piece 110b. The second positive elastic piece 1103 is soldered onto the second type of solder pad 20, and the second negative elastic piece 1104 is soldered onto the fourth type of solder pad 40. The second positive electrode of the second component 320b is electrically connected to the second positive elastic piece 1103, and the second negative electrode is electrically connected to the second negative elastic piece 1104. The second positive elastic piece 1103 is simultaneously soldered onto the first common solder pad 1, the second solder pad 21, and the second common solder pad 2 of the second type of solder pad 20. The positive electrode circuit of the main board 101 is conducted to the second positive elastic piece 1103 simultaneously through the first common solder pad 1 and the second solder pad 21, to be conducted to the second positive electrode of the second component 320b. The second negative elastic piece 1104 is simultaneously soldered onto the fifth sub-solder pad 411, the third common solder pad 3, and the sixth sub-solder pad 412 of the fourth type of solder pad 40. The negative electrode circuit of the main board 101 is conducted to the second negative elastic piece 1104 simultaneously through the fifth sub-solder pad 411, the third common solder pad 3, and the sixth sub-solder pad 412, to be conducted to the second negative electrode of the second component 320b, so that the second component 320b is electrically connected to the main board 101.

In this embodiment, the first common solder pad 1, the second common solder pad 2, and the third common solder pad 3 are arranged. The first type of solder pad 10 and the second type of solder pad 20 share the first common solder pad 1, the second type of solder pad 20 and the third type of solder pad 30 share the second common solder pad 2, and the third type of solder pad 30 and the fourth type of solder pad 40 share the third common solder pad 3. The solder pad 102 is segmented, so that two different elastic pieces 110 can be soldered onto the solder pad 102. In this way, the same main board 101 can be electrically connected to two different electronic components 320, the area of the solder pad 102 is reduced, and utilization of the main board 101 is improved, thereby reducing costs. In addition, an area of each type of solder pad 102 is approximately the same as an area of the corresponding elastic piece 110, and the solder pad 102 is separated, so that a large deviation in a soldering position caused by solder floating during soldering can be avoided, accuracy of a soldering position of the elastic piece 110 is improved, and stability of elastic connection of the elastic piece 110 is ensured.

In addition, in this embodiment, the second common solder pad 2 is set to be insulated from the main board 101, so that the second common solder pad 2 is used only for fixed connection, and is not conductive, thereby avoiding a short circuit in the second common solder pad 2 when the second type of solder pad 20 is electrically connected to the positive electrode circuit, and the third type of solder pad 30 is electrically connected to the negative electrode circuit.

In a second implementation, a difference between this implementation and the first implementation lies in that the first sub-solder pad 111, the second sub-solder pad 112, the first common solder pad 1, and the second solder pad 21 are all electrically connected to the negative electrode circuit of the main board 101, and are used as the negative electrode of the main board 101. The seventh sub-solder pad 311, the eighth sub-solder pad 312, the fifth sub-solder pad 411, the sixth sub-solder pad 412, and the third common solder pad 3 are all electrically connected to the positive electrode circuit of the main board 101, and are used as the positive electrode of the main board 101. The second common solder pad 2 is insulated from the main board 101. When the electronic component 320 is the first component, the first positive elastic piece 1101 is soldered onto the third type of solder pad 30, and the first negative elastic piece 1102 is soldered onto the first type of solder pad 10. When the electronic component 320 is the second component 320b, the second positive elastic piece 1103 is soldered onto the fourth type of solder pad 40, and the second negative elastic piece 1104 is soldered onto the second type of solder pad 20.

In a third implementation, the first common solder pad 1 is electrically connected to the positive electrode circuit of the main board 101, and is used as the positive electrode of the main board 101. The third common solder pad 3 is electrically connected to the negative electrode circuit of the main board 101, and is used as the negative electrode of the main board 101. The first solder pad 11, the second solder pad 21, the third solder pad 31, the fourth solder pad 41, and the second common solder pad 2 are all insulated from the main board 101, are neither used as the positive electrode of the main board 101 nor used as the negative electrode of the main board 101, and is used for fixed connection.

When the electronic component 320 is the first component, the first positive elastic piece 1101 is soldered onto the first type of solder pad 10, and the first negative elastic piece 1102 is soldered onto the third type of solder pad 30. The positive electrode circuit of the main board 101 is conducted to the first positive elastic piece 1101 through the first common solder pad 1, to be conducted to the first positive electrode of the first component. The negative electrode circuit of the main board 101 is conducted to the first negative elastic piece 1102 through the third common solder pad 3, to be conducted to the first negative electrode of the first component, so that the first component is electrically connected to the main board 101.

When the electronic component 320 is the second component 320b, the second positive elastic piece 1103 is soldered onto the second type of solder pad 20, and the second negative elastic piece 1104 is soldered onto the fourth type of solder pad 40. The positive electrode circuit of the main board 101 is conducted to the second positive elastic piece 1103 through the first common solder pad 1, to be conducted to the second positive electrode of the second component 320b. The negative electrode circuit of the main board 101 is conducted to the second negative elastic piece 1104 through the third common solder pad 3, to be conducted to the second negative electrode of the second component 320b, so that the second component 320b is electrically connected to the main board 101.

In this embodiment, the first common solder pad 1 and the third common solder pad 3 are used as electrical connection regions, and other regions are only used as fixed connection regions, so that the first common solder pad 1 can electrically connect the first positive elastic piece 1101 to the main board 101, and electrically connect the second positive elastic piece 1103 to the main board 101. The third common solder pad 3 can electrically connect the first negative elastic piece 1102 to the main board 101 and electrically connect the second negative elastic piece 1104 to the main board 101, thereby simplifying the structure of the solder pad 102.

In a fourth implementation, a difference between this implementation and the third implementation lies in that the first common solder pad 1 is electrically connected to the negative electrode circuit of the main board 101, and is used as the negative electrode of the main board 101. The third common solder pad 3 is electrically connected to the positive electrode circuit of the main board 101, and is used as the positive electrode of the main board 101. The first solder pad 11, the second solder pad 21, the third solder pad 31, the fourth solder pad 41, and the second common solder pad 2 are all insulated from the main board 101. When the electronic component 320 is the first component, the first positive elastic piece 1101 is soldered onto the third type of solder pad 30, and the first negative elastic piece 1102 is soldered onto the first type of solder pad 10. When the electronic component 320 is the second component 320b, the second positive elastic piece 1103 is soldered onto the fourth type of solder pad 40, and the second negative elastic piece 1104 is soldered onto the second type of solder pad 20.

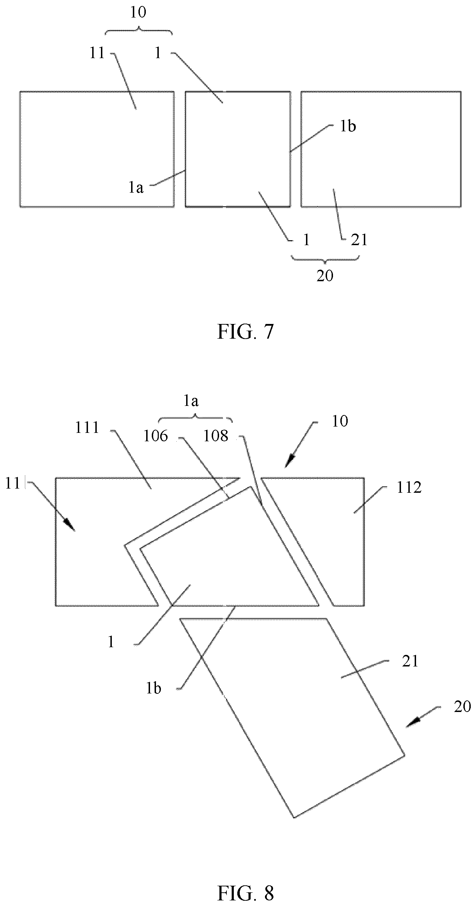

Refer to FIG. 7. FIG. 7 is a schematic diagram of a partial structure of a circuit board 100 according to a comparative example.

Solder pad 102 includes the first type of solder pad 10 and the second type of solder pad 20. The first type of solder pad 10 includes the first solder pad 11 and the first common solder pad 1. The second type of solder pad 20 includes the first common solder pad 1 and the second solder pad 21. The length direction of the first type of solder pad 10 is parallel to the length direction of the second type of solder pad 20. The first common solder pad 1 includes the first side 1a and the second side 1b. The first side 1a and the second side 1b are arranged oppositely. The first solder pad 11, the first common solder pad 1, and the second solder pad 21 are arranged side by side and spaced apart in the length direction of the first type of solder pad 10, and the first common solder pad 1 is located between the first solder pad 11 and the second solder pad 21. The first solder pad 11 is located on the first side 1a, and the second solder pad 21 is located on the second side 1b. That is, the first solder pad 11, the first common solder pad 1, and the second solder pad 21 are arranged in a straight line. A width of a gap between the first common solder pad 1 and the first solder pad 11 ranges from 0.15 mm to 0.25 mm, and a width of a gap between the first common solder pad 1 and the second solder pad 21 ranges from 0.15 mm to 0.25 mm. Both the gap between the first common solder pad 1 and the first solder pad 11 and the gap between the first common solder pad 1 and the second solder pad 21 are filled with the solder resist, to separate the first common solder pad 1 from the first solder pad 11 and the second solder pad 21, preventing the solder from flowing between the first common solder pad 1 and the first solder pad 11 and between the first common solder pad 1 and the second solder pad 21.

The first solder pad 11 and the first common solder pad 1 are configured to be simultaneously connected to the first component. In this case, the second solder pad 21 is vacant. The second solder pad 21 and the first common solder pad 1 are configured to be simultaneously connected to the second component 320b. In this case, the first solder pad 11 is vacant. This embodiment may be implemented in the following implementations.

In a first example, the first solder pad 11, the first common solder pad 1, and the second solder pad 21 are all electrically connected to the positive electrode circuit of the main board 101, and are used as the positive electrode of the main board 101. When the electronic component 320 is the first component, the first positive elastic piece 1101 is simultaneously soldered onto and electrically connected to the first solder pad 11 and the first common solder pad 1, and the first positive electrode of the first component is conducted to the first positive elastic piece 1101, so that the first component is electrically connected to the main board 101. When the electronic component 320 is the second component 320b, the second positive elastic piece 1103 is simultaneously soldered onto and electrically connected to the second solder pad 21 and the first common solder pad 1, and the second positive electrode of the second component 320b is conducted to the second negative elastic piece 1104, so that the second component 320b is electrically connected to the main board 101.

In this example, the first common solder pad 1 is arranged, and the first common solder pad 1 is used as both a part of the first type of solder pad 10 and a part of the second type of solder pad 20, so that the area of the solder pad 102 can be reduced. In addition, when jointly used, the first common solder pad 1 and the first solder pad 11 may be configured to be connected to the first component, and when jointly used, the first common solder pad 1 and the second solder pad 21 may be configured to be connected to the second component 320b, so that the same main board 101 can be electrically connected to two different electronic components 320, and utilization of the main board 101 is improved, thereby reducing costs. In addition, the first common solder pad 1 is spaced apart from both the first solder pad 11 and the second solder pad 21, so that the large deviation in the soldering position caused by the solder floating during soldering can be avoided, the accuracy of the soldering position of the elastic piece 110 is improved, and the stability of the elastic connection of the elastic piece 110 is ensured.

In a second example, a difference between this example and the first example lies in that the first solder pad 11, the first common solder pad 1, and the second solder pad 21 are all electrically connected to the negative electrode circuit of the main board 101, and are used as the negative electrode of the main board 101. When the electronic component 320 is the first component, the first negative elastic piece 1102 is simultaneously soldered onto and electrically connected to the first solder pad 11 and the first common solder pad 1. When the electronic component 320 is the second component 320b, the second negative elastic piece 1104 is simultaneously soldered onto and electrically connected to the second solder pad 21 and the first common solder pad 1.

In a third example, the first common solder pad 1 is electrically connected to the positive electrode circuit of the main board 101, and is used as the positive electrode of the main board 101. Both the first solder pad 11 and the second solder pad 21 are insulated from the main board 101. When the electronic component 320 is the first component, the first positive elastic piece 1101 is soldered onto the first type of solder pad 10, and is electrically connected to the first common solder pad 1, so that the main board 101 is conducted to the first positive electrode of the first component. When the electronic component 320 is the second component 320b, the second positive elastic piece 1103 is soldered onto the second type of solder pad 20, and is electrically connected to the first common solder pad 1, so that the main board 101 is conducted to the second positive electrode of the second component 320b.

In a fourth example, a difference between this implementation and the third implementation lies in that the first common solder pad 1 is electrically connected to the negative electrode circuit of the main board 101, and is used as the negative electrode of the main board 101. Both the first solder pad 11 and the second solder pad 21 are insulated from the main board 101.

In a fifth example, the first solder pad 11 is electrically connected to the positive electrode circuit of the main board 101, and is used as the positive electrode of the main board 101. The second solder pad 21 is electrically connected to the negative electrode circuit of the main board 101, and is used as the negative electrode of the main board 101. The first common solder pad 1 is insulated from the main board 101. When the electronic component 320 is the first component, the first positive elastic piece 1101 is soldered onto the first solder pad 11 and the first common solder pad 1, and is electrically connected to the first solder pad 11. The first positive electrode of the first component is electrically connected to the first positive elastic piece 1101, so that the first component is electrically connected to the main board 101. When the electronic component 320 is the second component 320b, the second negative elastic piece 1104 is soldered onto the second solder pad 21 and the first common solder pad 1 and is electrically connected to the second solder pad 21. The second negative electrode of the second component 320b is electrically connected to the second negative elastic piece 1104, so that the second component 320b is electrically connected to the main board 101.

In other examples, the first solder pad 11 may alternatively be electrically connected to the negative electrode circuit of the main board 101, the second solder pad 21 is electrically connected to the positive electrode circuit of the main board 101, and the first common solder pad is insulated from the main board 101. In conclusion, when polarities of the first solder pad 11 and the second solder pad 21 are different, the first common solder pad 1 only needs to be insulated from the main board 101.

Refer to FIG. 8. FIG. 8 is a schematic diagram of a partial structure of a circuit board 100 according to another comparative example.

The length direction of the first type of solder pad 10 intersects with the length direction of the second type of solder pad 20. The first type of solder pad 10 includes the first sub-solder pad 111 and the second sub-solder pad 112. The first common solder pad 1 includes the first side 1a and the second side 1b. The first side 1a includes a first sub-side 106 and a second sub-side 108. The first sub-solder pad 111 is located on the first sub-side 106, and the second sub-solder pad 112 is located on the second sub-side 108. In the length direction of the first type of solder pad 10, the first sub-solder pad 111, the first common solder pad 1, and the second sub-solder pad 112 are arranged side by side and spaced apart. The second solder pad 21 is located on the second side 1b of the first common solder pad 1, and is arranged side by side with and spaced apart from the first common solder pad 1.

The first sub-solder pad 111, the first common solder pad 1, and the second sub-solder pad 112 are configured to be simultaneously connected to the first component, and the second solder pad 21 and the first common solder pad 1 are configured to be simultaneously connected to the second component 320b. In an example, the first sub-solder pad 111, the second sub-solder pad 112, the first common solder pad 1, and the second solder pad 21 are all electrically connected to the positive electrode circuit of the main board 101. When the electronic component 320 is the first component, the first positive elastic piece 1101 is simultaneously soldered onto and electrically connected to the first sub-solder pad 111, the first common solder pad 1, and the second sub-solder pad 112. The first positive elastic piece 1101 is electrically connected to the first positive electrode of the first component, so that the first component is electrically connected to the main board 101. When the electronic component 320 is the second component 320b, the second positive elastic piece 1103 is simultaneously soldered onto and electrically connected to the second solder pad 21 and the first common solder pad 1. The second positive elastic piece 1103 is electrically connected to the second positive electrode of the second component 320b, so that the second component 320b is electrically connected to the main board 101.

In other examples, the first sub-solder pad 111, the second sub-solder pad 112, the first common solder pad 1, and the second solder pad 21 may alternatively be all electrically connected to the negative electrode circuit of the main board 101. Alternatively, the first common solder pad 1 is electrically connected to the positive electrode circuit or the negative electrode circuit of the main board 101, and the first sub-solder pad 111, the second sub-solder pad 112, and the second solder pad 21 are insulated from the main board 101. Alternatively, both the first sub-solder pad 111 and the second sub-solder pad 112 are electrically connected to the positive electrode circuit of the main board 101, the second solder pad 21 is electrically connected to the negative electrode circuit of the main board 101, the first common solder pad 1 is insulated from the main board 101, the first type of solder pad 10 is configured to be connected to the first positive elastic piece 1101, and the second type of solder pad 20 is configured to be connected to the second negative elastic piece 1104. Alternatively, both the second sub-solder pad 112 and the second sub-solder pad 112 are electrically connected to the negative electrode circuit of the main board 101, the second solder pad 21 is electrically connected to the positive electrode circuit of the main board 101, the first common solder pad 1 is insulated from the main board 101, the first type of solder pad 10 is configured to be connected to the first negative elastic piece 1102, and the second type of solder pad 20 is configured to be connected to the second positive elastic piece 1103.

In this example, the first common solder pad 1 is arranged, and the first common solder pad 1 is used as both a part of the first type of solder pad 10 and a part of the second type of solder pad 20, so that the area of the solder pad 102 can be reduced. In addition, when jointly used, the first common solder pad 1 and the first solder pad 11 may be configured to be connected to the first component, and when jointly used, the first common solder pad 1 and the second solder pad 21 may be configured to be connected to the second component 320b, so that the same main board 101 can be electrically connected to two different electronic components 320, and utilization of the main board 101 is improved, thereby reducing costs. In addition, in this example, the length direction of the first type of solder pad 10 intersects with the length direction of the second type of solder pad 20, so that the solder pad 102 can be applied to two different electronic components 320, thereby improving utilization of the circuit board 100.

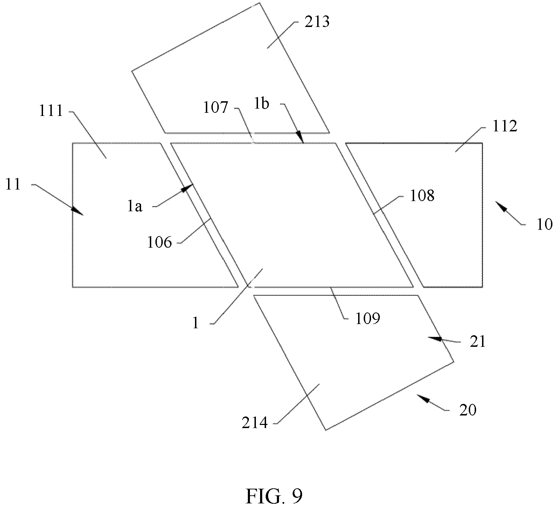

Refer to FIG. 9. FIG. 9 is a schematic diagram of a partial structure of a circuit board 100 according to a further comparative example.

The second solder pad 21 includes a third sub-solder pad 213 and a fourth sub-solder pad 214. The length direction of the first type of solder pad 10 intersects with the length direction of the second type of solder pad 20, jointly forming an X-shaped structure. The first common solder pad 1 is a parallelogram. The first common solder pad 1 includes the first side 1a and the second side 1b. The first side 1a includes the first sub-side 106 and the second sub-side 108. The second side 1b includes a third sub-side 107 and a fourth sub-side 109. The first sub-side 106, the third sub-side 107, the second sub-side 108, and the fourth sub-side 109 are connected end to end. The first sub-side 106 is arranged opposite to the second sub-side 108, and the third sub-side 107 is arranged opposite to the fourth sub-side 109. The seventh sub-solder pad 311, the first common solder pad 1, and the second sub-solder pad 112 are arranged side by side and spaced apart, and the first sub-solder pad 111 is located on a side of the first common solder pad 1 close to the first sub-side 106, and is spaced apart from the first sub-side 106. The second sub-solder pad 112 is located on a side close to the second sub-side 108, and is spaced apart from the second sub-side 108. The third sub-solder pad 213, the first common solder pad 1, and the fourth sub-solder pad 214 are arranged side by side and spaced apart. The third sub-solder pad 213 is located on a side of the first common solder pad 1 close to the third sub-side 107, and is spaced apart from the third sub-side 107. The fourth sub-solder pad 214 is located on a side close to the fourth sub-side 109, and is spaced apart from the fourth sub-side 109.

The first sub-solder pad 111, the first common solder pad 1, and the second sub-solder pad 112 are configured to be simultaneously connected to the first component. In this case, the third sub-solder pad 213 and the fourth sub-solder pad 214 are vacant. The third sub-solder pad 213, the fourth sub-solder pad 214, and the first common solder pad 1 are configured to be simultaneously connected to the second component 320b. In this case, the first sub-solder pad 111 and the second sub-solder pad 112 are vacant.
In this example, the first common solder pad 1 is arranged, and the first common solder pad 1 is used as both a part of the first type of solder pad 10 and a part of the second type of solder pad 20, so that the area of the solder pad 102 can be reduced. In addition, when jointly used, the first common solder pad 1 and the first solder pad 11 may be configured to be connected to the first component, and when jointly used, the first common solder pad 1 and the second solder pad 21 may be configured to be connected to the second component 320b, so that the same main board 101 can be electrically connected to two different electronic components 320, and utilization of the main board 101 is improved, thereby reducing costs. In addition, in this embodiment, the length direction of the first type of solder pad 10 intersects with the length direction of the second type of solder pad 20, so that the solder pad 102 can be applied to two different electronic components 320, thereby improving utilization of the circuit board 100. In addition, the first common solder pad 1 is spaced apart from both the first solder pad 11 and the second solder pad 21, so that the large deviation in the soldering position caused by the solder floating during soldering can be avoided, the accuracy of the soldering position of the elastic piece 110 is improved, and the stability of the elastic connection of the elastic piece 110 is ensured.

## Claims

1. An electronic device (500), comprising a first component (320), a second component (320b) and a circuit board (100);
wherein the circuit board comprises a main board (101), a first type of solder pad (10), and a second type of solder pad (20);
both the first type of solder pad and the second type of solder pad are formed on a surface of the main board, and are electrically connected to the main board;
the first type of solder pad comprises a first solder pad (11) and a first common solder pad (1), and the second type of solder pad comprises a second solder pad (21) and the first common solder pad; and the first common solder pad comprises a first side (1a) and a second side (1b), and the first solder pad and the second solder pad are respectively located on the first side and the second side, and are spaced apart from the first common solder pad; and
the first solder pad and the first common solder pad are configured to be simultaneously connected to the first component, and the second solder pad and the first common solder pad are configured to be simultaneously connected to the second component;
wherein when the first solder pad and the first common solder pad are configured to be simultaneously connected to the first component, the second solder pad is vacant, and when the second solder pad and the first common solder pad are configured to be simultaneously connected to the second component, the first solder pad is vacant;
wherein the second type of solder pad further comprises a second common solder pad (2), the second common solder pad is spaced apart from the second solder pad and the first common solder pad, and the second common solder pad, the second solder pad, and the first common solder pad are configured to be simultaneously connected to the second component; and
the circuit board further comprises a third type of solder pad (30), the third type of solder pad is formed on the surface of the main board, and is arranged side by side with and spaced apart from the first type of solder pad, the third type of solder pad comprises a third solder pad (31) and the second common solder pad, the third solder pad is spaced apart from the second common solder pad, and the second common solder pad and the third solder pad are configured to be simultaneously connected to the first component.

2. The electronic device according to claim 1, wherein a first gap is provided between the first solder pad and the first common solder pad, and an area of the first gap is less than or equal to 20% of a total area of the first solder pad, the first gap, and the first common solder pad.

3. The electronic device according to claim 2, wherein a solder resist is arranged on the surface of the main board, and the solder resist is located in the first gap.

4. The electronic device according to any one of claims 1 to 3, wherein a length direction of the first type of solder pad intersects with a length direction of the second type of solder pad.

5. The electronic device according to claim 4, wherein the first solder pad comprises a first sub-solder pad (111) and a second sub-solder pad (112), the first sub-solder pad, the first common solder pad, and the second sub-solder pad are arranged side by side and spaced apart in the length direction of the first type of solder pad, the first common solder pad is located between the first sub-solder pad and the second sub-solder pad, the first side comprises a first sub-side (106) and a second sub-side (108), the first sub-solder pad is located on the first sub-side, and the second sub-solder pad is located on the second sub-side.

6. The electronic device according to claim 5, wherein the second solder pad comprises a third sub-solder pad (213) and a fourth sub-solder pad (214), and the third sub-solder pad, the first common solder pad, and the fourth sub-solder pad are arranged side by side and spaced apart in the length direction of the second type of solder pad, the first common solder pad is located between the third sub-solder pad and the fourth sub-solder pad, the second side comprises a third sub-side (107) and a fourth sub-side (109), the third sub-solder pad is located on the third sub-side, and the fourth sub-solder pad is located on the fourth sub-side.

7. The electronic device according to any one of claims 1 to 3, wherein a length direction of the first type of solder pad is parallel to a length direction of the second type of solder pad; and the first solder pad, the first common solder pad, and the second solder pad are arranged side by side and spaced apart in the length direction of the first type of solder pad, and the first common solder pad is located between the first solder pad and the second solder pad.

8. The electronic device according to any one of claims 1 to 3, wherein the main board comprises a positive electrode circuit and a negative electrode circuit, the first common solder pad is electrically connected to the positive electrode circuit, and both the first solder pad and the second solder pad are electrically insulated from the main board; or the first common solder pad is electrically connected to the negative electrode circuit, and both the first solder pad and the second solder pad are electrically insulated from the main board, wherein both the first solder pad and the second solder pad are only used for mechanical fixation and have no electrical function.

9. The electronic device according to any one of claims 1 to 3, wherein the main board comprises a positive electrode circuit and a negative electrode circuit, the first solder pad is electrically connected to the positive electrode circuit, the second solder pad is electrically connected to the negative electrode circuit, and the first common solder pad is electrically insulated from the main board; or the first solder pad is electrically connected to the negative electrode circuit, the second solder pad is electrically connected to the positive electrode circuit, and the first common solder pad is electrically insulated from the main board, wherein the first common solder pad is only used for mechanical fixation and has no electrical function.

10. The electronic device according to claim 1, wherein a third gap is provided between the first common solder pad and the second solder pad, and a fourth gap is provided between the second solder pad and the second common solder pad; and a total area of the third gap and the fourth gap is less than or equal to 20% of a total area of the first common solder pad, the second solder pad, the second common solder pad, the third gap, and the fourth gap.

11. The electronic device according to claim 1, wherein a region in which the first solder pad and the first common solder pad are located is a first region, a region in which the second solder pad, the first common solder pad, and the second common solder pad are located is a second region, and at least one of a length and a width of the first region is different from a length of the second region, or is different from a width of the second region.

12. The electronic device according to claim 1, wherein the third type of solder pad further comprises a third common solder pad (3), the third common solder pad is spaced apart from the third solder pad and the second common solder pad, and the third common solder pad, the third solder pad, and the second common solder pad are configured to be simultaneously connected to the first component; and
the circuit board further comprises a fourth type of solder pad (40), the fourth type of solder pad is formed on the surface of the main board, and is arranged side by side with and spaced apart from the second type of solder pad, the fourth type of solder pad comprises a fourth solder pad (41) and the third common solder pad (3), the fourth solder pad is spaced apart from the third common solder pad, and the third common solder pad and the fourth solder pad are configured to be simultaneously connected to the second component.

13. The electronic device according to any one of claims 1 to 12, wherein electronic device further comprises a first elastic piece or a second elastic piece;
the first elastic piece is soldered onto the first solder pad and the first common solder pad, or the second elastic piece is soldered onto the second solder pad and the first common solder pad;
the first component is electrically connected to the first elastic piece, or the second component is electrically connected to the second elastic piece.

## Patentansprüche

1. Elektronisches Gerät (500), umfassend eine erste Komponente (320), eine zweite Komponente (320b) und eine Leiterplatte (100);
wobei die Leiterplatte eine Hauptplatine (101), einen ersten Typ von Lötpad (10) und einen zweiten Typ von Lötpad (20) umfasst;
sowohl der erste Typ von Lötpad als auch der zweite Typ von Lötpad sind auf einer Oberfläche der Hauptplatine ausgebildet und elektrisch mit der Hauptplatine verbunden;
der erste Typ von Lötpad umfasst ein erstes Lötpad (11) und ein erstes gemeinsames Lötpad (1), und der zweite Typ von Lötpad umfasst ein zweites Lötpad (21) und das erste gemeinsame Lötpad; und das erste gemeinsame Lötpad umfasst eine erste Seite (1a) und eine zweite Seite (1b), und das erste Lötpad sowie das zweite Lötpad sind jeweils auf der ersten Seite und der zweiten Seite angeordnet und vom ersten gemeinsamen Lötpad beabstandet; und
das erste Lötpad und das erste gemeinsame Lötpad sind so konfiguriert, dass sie gleichzeitig mit der ersten Komponente verbunden sind, und das zweite Lötpad und das erste gemeinsame Lötpad sind so konfiguriert, dass sie gleichzeitig mit der zweiten Komponente verbunden sind;
wobei, wenn das erste Lötpad und das erste gemeinsame Lötpad so konfiguriert sind, dass sie gleichzeitig mit der ersten Komponente verbunden sind, das zweite Lötpad frei bleibt, und wenn das zweite Lötpad und das erste gemeinsame Lötpad so konfiguriert sind, dass sie gleichzeitig mit der zweiten Komponente verbunden sind, das erste Lötpad frei bleibt;
wobei der zweite Typ von Lötpad ferner ein zweites gemeinsames Lötpad (2) umfasst, das zweite gemeinsame Lötpad vom zweiten Lötpad und dem ersten gemeinsamen Lötpad beabstandet ist, und das zweite gemeinsame Lötpad, das zweite Lötpad und das erste gemeinsame Lötpad so konfiguriert sind, dass sie gleichzeitig mit der zweiten Komponente verbunden sind; und
die Leiterplatte ferner einen dritten Typ von Lötpad (30) umfasst, wobei der dritte Typ von Lötpad auf der Oberfläche der Hauptplatine ausgebildet ist und Seite an Seite mit dem ersten Typ von Lötpad angeordnet und von diesem beabstandet ist, der dritte Typ von Lötpad ein drittes Lötpad (31) und das zweite gemeinsame Lötpad umfasst, das dritte Lötpad vom zweiten gemeinsamen Lötpad beabstandet ist und das zweite gemeinsame Lötpad und das dritte Lötpad so konfiguriert sind, dass sie gleichzeitig mit der ersten Komponente verbunden sind.

2. Elektronisches Gerät nach Anspruch 1, wobei ein erster Spalt zwischen dem ersten Lötpad und dem ersten gemeinsamen Lötpad vorgesehen ist und ein Bereich des ersten Spalts kleiner oder gleich 20 % eines Gesamtbereichs des ersten Lötpads, des ersten Spalts und des ersten gemeinsamen Lötpads ist.

3. Elektronische Vorrichtung nach Anspruch 2, wobei ein Lötstopplack auf der Oberfläche der Hauptplatine angeordnet ist und der Lötstopplack in dem ersten Spalt angeordnet ist.

4. Elektronische Vorrichtung nach einem der Ansprüche 1 bis 3, wobei eine Längsrichtung des ersten Typs von Lötaugen eine Längsrichtung des zweiten Typs von Lötaugen schneidet.

5. Elektronische Vorrichtung nach Anspruch 4, wobei das erste Lötauge ein erstes Teil-Lötauge (111) und ein zweites Teil-Lötauge (112) umfasst, wobei das erste Teil-Lötauge, das erste gemeinsame Lötauge und das zweite Teil-Lötauge nebeneinander angeordnet und in der Längsrichtung des ersten Typs von Lötaugen voneinander beabstandet sind, das erste gemeinsame Lötauge zwischen dem ersten Teil-Lötauge und dem zweiten Teil-Lötauge angeordnet ist, die erste Seite eine erste Teilseite (106) und eine zweite Teilseite (108) umfasst, das erste Teil-Lötauge auf der ersten Teilseite angeordnet ist und das zweite Teil-Lötauge auf der zweiten Teilseite angeordnet ist.

6. Elektronische Vorrichtung nach Anspruch 5, wobei das zweite Lötauge ein drittes Teil-Lötauge (213) und ein viertes Teil-Lötauge (214) umfasst, und das dritte Teil-Lötauge, das erste gemeinsame Lötauge und das vierte Teil-Lötauge nebeneinander angeordnet und in der Längsrichtung des zweiten Typs von Lötaugen voneinander beabstandet sind, das erste gemeinsame Lötauge zwischen dem dritten Teil-Lötauge und dem vierten Teil-Lötauge angeordnet ist, die zweite Seite eine dritte Teilseite (107) und eine vierte Teilseite (109) umfasst, das dritte Teil-Lötauge auf der dritten Teilseite angeordnet ist und das vierte Teil-Lötauge auf der vierten Teilseite angeordnet ist.

7. Elektronische Vorrichtung nach einem der Ansprüche 1 bis 3, wobei eine Längsrichtung des ersten Typs von Lötaugen parallel zu einer Längsrichtung des zweiten Typs von Lötaugen verläuft; und das erste Lötauge, das erste gemeinsame Lötauge und das zweite Lötauge nebeneinander angeordnet und in der Längsrichtung des ersten Typs von Lötaugen voneinander beabstandet sind, und das erste gemeinsame Lötauge zwischen dem ersten Lötauge und dem zweiten Lötauge angeordnet ist.

8. Elektronische Vorrichtung nach einem der Ansprüche 1 bis 3, wobei die Hauptplatine eine positive Elektrodenschaltung und eine negative Elektrodenschaltung umfasst, das erste gemeinsame Lötauge elektrisch mit der positiven Elektrodenschaltung verbunden ist und sowohl das erste Lötauge als auch das zweite Lötauge elektrisch von der Hauptplatine isoliert sind; oder das erste gemeinsame Lötauge elektrisch mit der negativen Elektrodenschaltung verbunden ist und sowohl das erste Lötauge als auch das zweite Lötauge elektrisch von der Hauptplatine isoliert sind, wobei sowohl das erste Lötauge als auch das zweite Lötauge nur zur mechanischen Befestigung verwendet werden und keine elektrische Funktion haben.

9. Die elektronische Vorrichtung nach einem der Ansprüche 1 bis 3, wobei die Hauptplatine eine positive Elektrodenschaltung und eine negative Elektrodenschaltung umfasst, wobei das erste Lötpad elektrisch mit der positiven Elektrodenschaltung verbunden ist, das zweite Lötpad elektrisch mit der negativen Elektrodenschaltung verbunden ist und das erste gemeinsame Lötpad elektrisch von der Hauptplatine isoliert ist; oder das erste Lötpad ist elektrisch mit der negativen Elektrodenschaltung verbunden, das zweite Lötpad ist elektrisch mit der positiven Elektrodenschaltung verbunden und das erste gemeinsame Lötpad ist elektrisch von der Hauptplatine isoliert, wobei das erste gemeinsame Lötpad nur zur mechanischen Befestigung verwendet wird und keine elektrische Funktion hat.

10. Die elektronische Vorrichtung nach Anspruch 1, wobei ein dritter Spalt zwischen dem ersten gemeinsamen Lötpad und dem zweiten Lötpad vorgesehen ist und ein vierter Spalt zwischen dem zweiten Lötpad und dem zweiten gemeinsamen Lötpad vorgesehen ist; und wobei eine Gesamtfläche des dritten Spalts und des vierten Spalts kleiner oder gleich 20 % einer Gesamtfläche des ersten gemeinsamen Lötpads, des zweiten Lötpads, des zweiten gemeinsamen Lötpads, des dritten Spalts und des vierten Spalts ist.

11. Die elektronische Vorrichtung nach Anspruch 1, wobei ein Bereich, in dem sich das erste Lötpad und das erste gemeinsame Lötpad befinden, ein erster Bereich ist, ein Bereich, in dem sich das zweite Lötpad, das erste gemeinsame Lötpad und das zweite gemeinsame Lötpad befinden, ein zweiter Bereich ist, und wobei mindestens eine Länge oder eine Breite des ersten Bereichs sich von einer Länge des zweiten Bereichs unterscheidet oder sich von einer Breite des zweiten Bereichs unterscheidet.

12. Die elektronische Vorrichtung nach Anspruch 1, wobei die dritte Art von Lötpad ferner ein drittes gemeinsames Lötpad (3) umfasst, wobei das dritte gemeinsame Lötpad vom dritten Lötpad und dem zweiten gemeinsamen Lötpad beabstandet ist, und das dritte gemeinsame Lötpad, das dritte Lötpad und das zweite gemeinsame Lötpad so konfiguriert sind, dass sie gleichzeitig mit der ersten Komponente verbunden werden; und
die Leiterplatte ferner eine vierte Art von Lötpad (40) umfasst, wobei die vierte Art von Lötpad auf der Oberfläche der Hauptplatine ausgebildet ist und Seite an Seite mit der zweiten Art von Lötpad angeordnet und von dieser beabstandet ist, wobei die vierte Art von Lötpad ein viertes Lötpad (41) und das dritte gemeinsame Lötpad (3) umfasst, wobei das vierte Lötpad vom dritten gemeinsamen Lötpad beabstandet ist und das dritte gemeinsame Lötpad und das vierte Lötpad so konfiguriert sind, dass sie gleichzeitig mit der zweiten Komponente verbunden werden.

13. Die elektronische Vorrichtung nach einem der Ansprüche 1 bis 12, wobei die elektronische Vorrichtung ferner ein erstes elastisches Teil oder ein zweites elastisches Teil umfasst;
das erste elastische Teil ist auf das erste Lötpad und das erste gemeinsame Lötpad gelötet, oder das zweite elastische Teil ist auf das zweite Lötpad und das erste gemeinsame Lötpad gelötet;
die erste Komponente ist elektrisch mit dem ersten elastischen Teil verbunden, oder die zweite Komponente ist elektrisch mit dem zweiten elastischen Teil verbunden.

## Revendications

1. Dispositif électronique (500), comprenant un premier composant (320), un second composant (320b) et une carte de circuit imprimé (100) ;
dans lequel la carte de circuit imprimé comprend une carte principale (101), un premier type de plage d'accueil (10) et un second type de plage d'accueil (20) ;
le premier type de plage d'accueil et le second type de plage d'accueil sont tous deux formés sur une surface de la carte principale, et sont connectés électriquement à la carte principale ;
le premier type de plage d'accueil comprend une première plage d'accueil (11) et une première plage d'accueil commune (1), et le second type de plage d'accueil comprend une seconde plage d'accueil (21) et la première plage d'accueil commune ; et la première plage d'accueil commune comprend un premier côté (1a) et un second côté (1b), et la première plage d'accueil et la seconde plage d'accueil sont situées respectivement sur le premier côté et le second côté, et sont espacées de la première plage d'accueil commune ; et
la première plage d'accueil et la première plage d'accueil commune sont configurées pour être connectées simultanément au premier composant, et la seconde plage d'accueil et la première plage d'accueil commune sont configurées pour être connectées simultanément au second composant ;
dans lequel, lorsque la première plage d'accueil et la première plage d'accueil commune sont configurées pour être connectées simultanément au premier composant, la seconde plage d'accueil est vacante, et lorsque la seconde plage d'accueil et la première plage d'accueil commune sont configurées pour être connectées simultanément au second composant, la première plage d'accueil est vacante ;
dans lequel le second type de plage d'accueil comprend en outre une seconde plage d'accueil commune (2), la seconde plage d'accueil commune est espacée de la seconde plage d'accueil et de la première plage d'accueil commune, et la seconde plage d'accueil commune, la seconde plage d'accueil et la première plage d'accueil commune sont configurées pour être connectées simultanément au second composant ; et
la carte de circuit imprimé comprend en outre un troisième type de plage d'accueil (30), le troisième type de plage d'accueil est formé sur la surface de la carte principale, et est disposé côte à côte avec et espacé du premier type de plage d'accueil, le troisième type de plage d'accueil comprend une troisième plage d'accueil (31) et la seconde plage d'accueil commune, la troisième plage d'accueil est espacée de la seconde plage d'accueil commune, et la seconde plage d'accueil commune et la troisième plage d'accueil sont configurées pour être connectées simultanément au premier composant.

2. Dispositif électronique selon la revendication 1, dans lequel un premier intervalle est prévu entre la première plage d'accueil et la première plage d'accueil commune, et une aire du premier intervalle est inférieure ou égale à 20 % d'une aire totale de la première plage d'accueil, du premier intervalle et de la première plage d'accueil commune.

3. Dispositif électronique selon la revendication 2, dans lequel un vernis épargne est disposé sur la surface de la carte principale, et le vernis épargne est situé dans le premier espace.

4. Dispositif électronique selon l'une quelconque des revendications 1 à 3, dans lequel une direction de longueur du premier type de plage de soudure coupe une direction de longueur du second type de plage de soudure.

5. Dispositif électronique selon la revendication 4, dans lequel la première plage de soudure comprend une première sous-plage de soudure (111) et une deuxième sous-plage de soudure (112), la première sous-plage de soudure, la première plage de soudure commune et la deuxième sous-plage de soudure sont disposées côte à côte et espacées dans la direction de longueur du premier type de plage de soudure, la première plage de soudure commune est située entre la première sous-plage de soudure et la deuxième sous-plage de soudure, le premier côté comprend un premier sous-côté (106) et un deuxième sous-côté (108), la première sous-plage de soudure est située sur le premier sous-côt é, et la deuxième sous-plage de soudure est située sur le deuxième sous-côté.

6. Dispositif électronique selon la revendication 5, dans lequel la deuxième plage de soudure comprend une troisième sous-plage de soudure (213) et une quatrième sous-plage de soudure (214), et la troisième sous-plage de soudure, la première plage de soudure commune et la quatrième sous-plage de soudure sont disposées côte à côte et espacées dans la direction de longueur du second type de plage de soudure, la première plage de soudure commune est située entre la troisième sous-plage de soudure et la quatrième sous-plage de soudure, le deuxième côté comprend un troisième sous-côt é (107) et un quatrième sous-côté (109), la troisième sous-plage de soudure est située sur le troisiè me sous-côté, et la quatrième sous-plage de soudure est située sur le quatrième sous-côté.

7. Dispositif électronique selon l'une quelconque des revendications 1 à 3, dans lequel une direction de longueur du premier type de plage de soudure est parallèle à une direction de longueur du second type de plage de soudure ; et la première plage de soudure, la première plage de soudure commune et la deuxième plage de soudure sont disposées côte à côte et espacées dans la direction de longueur du premier type de plage de soudure, et la première plage de soudure commune est situ ée entre la première plage de soudure et la deuxième plage de soudure.

8. Dispositif électronique selon l'une quelconque des revendications 1 à 3, dans lequel la carte principale comprend un circuit d'électrode positive et un circuit d'électrode négative, la première plage de soudure commune est connectée électriquement au circuit d'électrode positive, et à la fois la première plage de soudure et la deuxième plage de soudure sont électriquement isolées de la carte principale ; ou la première plage de soudure commune est connectée électriquement au circuit d'é lectrode négative, et à la fois la première plage de soudure et la deuxième plage de soudure sont é lectriquement isolées de la carte principale, dans lequel à la fois la première plage de soudure et la deuxième plage de soudure sont uniquement utilisées pour la fixation mécanique et n'ont aucune fonction électrique.

9. Dispositif électronique selon l'une quelconque des revendications 1 à 3, dans lequel la carte principale comprend un circuit d'électrode positive et un circuit d'électrode négative, la première plage de soudure est électriquement connectée au circuit d'électrode positive, la deuxième plage de soudure est électriquement connectée au circuit d'électrode négative, et la première plage de soudure commune est électriquement isolée de la carte principale ; ou la première plage de soudure est é lectriquement connectée au circuit d'électrode négative, la deuxiè me plage de soudure est é lectriquement connectée au circuit d'électrode positive, et la première plage de soudure commune est électriquement isolée de la carte principale, dans lequel la première plage de soudure commune est uniquement utilisée pour la fixation mécanique et n'a aucune fonction électrique.

10. Dispositif électronique selon la revendication 1, dans lequel un troisième espace est prévu entre la première plage de soudure commune et la deuxième plage de soudure, et un quatrième espace est prévu entre la deuxième plage de soudure et la deuxième plage de soudure commune ; et une surface totale du troisième espace et du quatrième espace est inférieure ou égale à 20 % d'une surface totale de la première plage de soudure commune, de la deuxième plage de soudure, de la deuxième plage de soudure commune, du troisième espace et du quatrième espace.

11. Dispositif électronique selon la revendication 1, dans lequel une région dans laquelle la première plage de soudure et la première plage de soudure commune sont situées est une première région, une région dans laquelle la deuxième plage de soudure, la première plage de soudure commune et 1a deuxième plage de soudure commune sont situées est une deuxième région, et au moins l'une d'une longueur et d'une largeur de la première région est différente d'une longueur de la deuxième région, ou est différente d'une largeur de la deuxième région.

12. Dispositif électronique selon la revendication 1, dans lequel le troisième type de plage de soudure comprend en outre une troisième plage de soudure commune (3), la troisième plage de soudure commune est espacée de la troisième plage de soudure et de la deuxième plage de soudure commune, et la troisième plage de soudure commune, la troisième plage de soudure et la deuxième plage de soudure commune sont configurées pour être connectées simultanément au premier composant ; et
la carte de circuit imprimé comprend en outre un quatrième type de plage de soudure (40), le quatrième type de plage de soudure est formé sur la surface de la carte principale, et est disposé côte à côte avec et espacé du deuxième type de plage de soudure, le quatrième type de plage de soudure comprend une quatrième plage de soudure (41) et la troisième plage de soudure commune (3), la quatrième plage de soudure est espacée de la troisième plage de soudure commune, et la troisième plage de soudure commune et la quatrième plage de soudure sont configurées pour être connectées simultanément au deuxième composant.

13. Dispositif électronique selon l'une quelconque des revendications 1 à 12, dans lequel le dispositif électronique comprend en outre une première pièce élastique ou une deuxième pièce élastique ;
la première pièce élastique est soudée sur le premier plot de soudure et sur le premier plot de soudure commun, ou la deuxième pièce élastique est soudée sur le deuxième plot de soudure et sur le premier plot de soudure commun ;
le premier composant est connecté électriquement à la première pièce élastique, ou le deuxième composant est connecté électriquement à la deuxième pièce élastique.
